# DEMANDE DE BREVET EUROPEEN

(11) **EP 0 547 276 A1**
(43) Date de publication de la demande: **23.06.1993**
(21) Numéro de dépôt: 91420460.7
(22) Date de dépôt: 19.12.1991
(51) Int. Cl.: H03K 17/12, H03K 17/08

(54) **Interrupteur statique de puissance à semi-conducteurs**

(71) Demandeur: FERRAZ Société Anonyme, F-69003 Lyon (FR)
(72) Inventeur: de Palma, Jian Franco, 73390 Chateauneuf par Chamoux sur Gelon (FR); Rousseau, Jean-Jacques, F-42100 Saint Etienne (FR); Epron, Pierre, F-69008 Lyon (FR)
(74) Mandataire: Monnier, Guy

(57) **Abrégé**

Interrupteur statique apte à déclencher en cas de surintensités de plusieurs centaines d'ampères, voire de plus d'un millier d'ampères.

Au lieu d'utiliser un seul gros composant du commerce, on utilise un kyrielle de petits composants (I₁, I₂..., Iₙ) en parallèle chacun étant associé avec un circuit SNUBBER (S₁, S₂..., Sₙ).

## Description

La présente invention se rapporte à un interrupteur statique de puissance à semi-conducteurs.

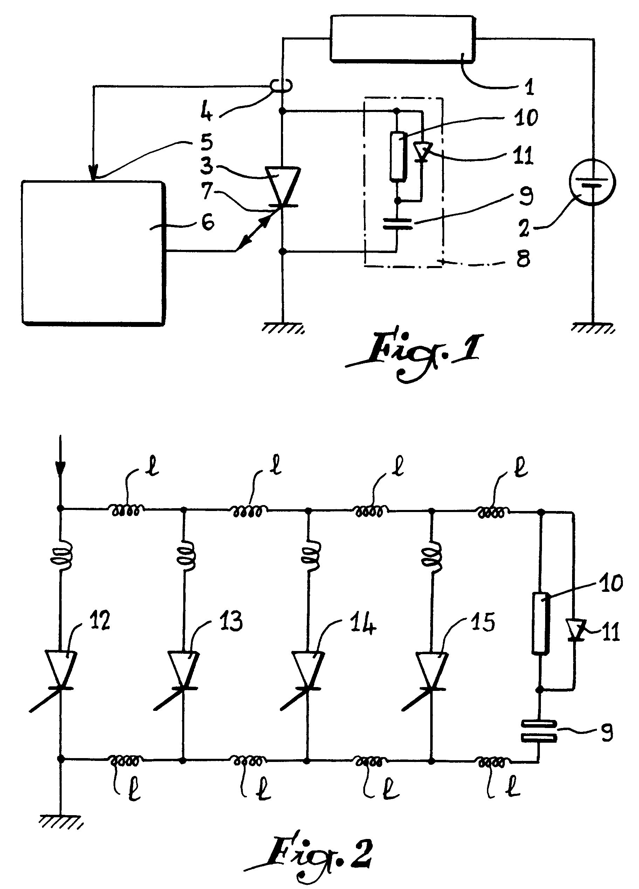

La fig. 1 du dessin annexé rappelle de manière très simplifiée le schéma d'un disjoncteur statique unidirectionnel de l'art connu. Dans cet exemple, la charge 1 est alimentée par une source 2 de tension continue et cette charge est branchée en série avec un commutateur de puissance 3 de type "GTO" (c'est-à-dire blocable par la gâchette).

Un capteur de courant 4 applique un signal image du courant de ligne sur une entrée 5 de basculement du circuit de commande 6 du thyristor 3. En cas de surintensité accidentelle, le seuil de basculement de ce circuit 6 est dépassé, et ce dernier commande par la gâchette 7 l'extinction du thyristor 3, ce qui coupe l'alimentation de la charge 1.

L'interrupteur statique que constitue le thyristor 3 ne peut cependant, en théorie et en pratique, pas fonctionner sans que soit prévu à ses bornes un Circuit 8 d'Aide à La Commutation 〈"C.A.L.C."〉, plus communément dénommé "SNUBBER", dont le rôle essentiel est de limiter la remontée de la tension à ses bornes au moment de l'ouverture de cet interrupteur 3.

Ce circuit SNUBBER 8, qui est classiquement constitué d'un condensateur 9 mis en série avec une résistance de décharge 10 shuntée par une diode 11 branchée en direct, fonctionne de la façon suivante :
A l'ouverture de l'interrupteur 3, la self-inductance de la charge 1 s'oppose naturellement à la décroissance du courant de ligne qui circule dans cette charge. En première approximation, ce courant reste donc constant immédiatement après l'ouverture, alors que, en l'absence de circuit SNUBBER, la tension aux bornes de l'interrupteur 3 (qui était nulle avant l'ouverture) subit une brusque augmentation, entraînant aux bornes de cet interrupteur une surtension qui est en général prohibitive et destructice.

Le circuit SNUBBER 8 étant présent, un condensateur 9 est branché aux bornes de l'interrupteur 3, condensateur dont la charge est nulle tant que cet interrupteur est fermé.

A l'ouverture, le courant de ligne reste, comme mentionné ci-dessus, pratiquement constant. Comme le courant dans l'interrupteur 3 subit alors une décroissance à peu près linéaire, il s'ensuit que le courant de charge du condensateur 9 subit la loi linéaire inverse, de sorte que la tension à ses bornes (et par suite la tension aux bornes de l'interrupteur 3), qui suit une loi de croissance qui est l'intégrale de cette dernière loi linéaire de variation du courant, varie finalement selon une loi parabolique. Cette tension remonte donc très lentement, de sorte que les pertes à l'ouverture dans le thyristor 3 sont acceptables.

La résistance 10 a pour rôle bien évident de limiter l'intensité du courant de décharge de ce condensateur 9 à la fermeture de l'interrupteur 3, tandis que la diode 11 vient naturellement shunter cette résistance lors de la charge à l'ouverture.

Dans le cas de circuits de forte puissance, par exemple lorsque la surintensité maximale admissible dans la charge est (pour fixer les idées) de l'ordre de 800 ampères, le thyristor 3 est classiquement choisi en conséquence parmi ceux normalement disponibles dans le commerce. Il en résulte un coût et un encombrement remarquablement élevés.

Si maintenant l'on souhaite pouvoir commuter une surintensité accidentelle de par exemple 1200 ampères, on utilisera classiquement deux gros thyristors du type précité, qui seront alors câblés en parallèle, avec un circuit SNUBBER par thyristor, les inconvénients d'un coût et d'un encombrement élevés subsistant.

L'invention vise à remédier à ces inconvénients et elle a pour objet l'interrupteur statique de puissance à semi-conducteurs qui est défini à la revendication 1.

En fait cet interrupteur est constitué de façon modulaire par le branchement en parallèle d'un grand nombre de petits interrupteurs statiques de faibles dimensions et caractéristiques de coupure, et d'une pluralité de circuits SNUBBER" aptes chacun à protéger soit un ou soit deux de ces petits interrupteurs. Chacun de ces petits interrupteurs statiques est choisi parmi ceux qui sont donnés par le constructeur pour une intensité de coupure plus faible que la surintensité que ce petit interrupteur doit, pour sa part, normalement couper dans ce montage, en cas de fonctionnement en surcharge de courant, compte-tenu de son branchement en parallèle avec les autres petits interrupteurs précités.

Le dessin annexé, donné à titre d'exemple, permettra de mieux comprendre l'invention, les caractéristiques qu'elle présente et les avantages qu'elle est susceptible de procurer :
Fig. 1 rappelle l'état de la technique, comme ci-dessus indiqué.
Fig. 2 est un schéma facilitant la compréhension de l'essence de l'invention et
Fig. 3 est un schéma synoptique de cet interrupteur statique.

Basiquement, l'invention part de l'idée, plutôt étrange à priori, de remplacer, pour réaliser un interrupteur statique pour très forts courants, l'interrupteur statique 3 (fig. 1) du commerce par un grand nombre de petits interrupteurs statiques, aptes chacun à commuter une surintensité bien plus faible que celle pour laquelle est prévu l'interrupteur classique 3 de l'art antérieur, ces petits interrupteurs étant alors branchés en parallèle.

L'application simple de cette idée conduirait cependant à un montage incapable de fonctionner dans cette technique particulière de la disjonction de très forts courants.

La démonstration de cette impossibilité ressort de la fig. 2, qui représente ce que donnerait en pratique le montage en parallèle d'un grand nombre (supposé ici égal à quatre pour ne pas alourdir le dessin) de ces composants.

Ce montage, qui est celui qui vient naturellement à l'esprit, est composé de plusieurs thyristors 12, 13, 14, 15 en parallèle, et d'un circuit SNUBBER 8 en parallèle sur l'ensemble. Cependant, compte-tenu des très forts courants à commuter et des très faibles temps de commutation de ces courants, il n'est en réalité pas possible de faire abstraction des self-inductances ℓ des connexions entre thyristors 12, 13, 14, 15 et entre le dernier thyristor 15 et le SNUBBER commun 8 ainsi que des self-inductances des composants.

On a vu précédemment, en référence à la fig. 1, que le rôle du condensateur 9 du SNUBBER est de s'opposer à la remontée brusque de la tension dans l'interrupteur statique qu'il protège, lors de l'ouverture de cet interrupteur. Cependant, en raison des fortes variations de courant dans chaque self ℓ , ces dernières créent une surtension, de sorte que si le SNUBBER 8 reste cependant efficace pour protéger le thyristor le plus proche 15, il l'est beaucoup moins pour protéger le thyristor 14, encore moins pour protéger le thyristor 13, etc..., les self-inductances ℓ additionnant leurs effet de surtension au fur et à mesure que l'on s'éloigne de ce SNUBBER 8. La mise en parallèle, dans ce type d'application, de ces thyristors multiples 12 à 15, ne peut donc à priori pas fonctionner.

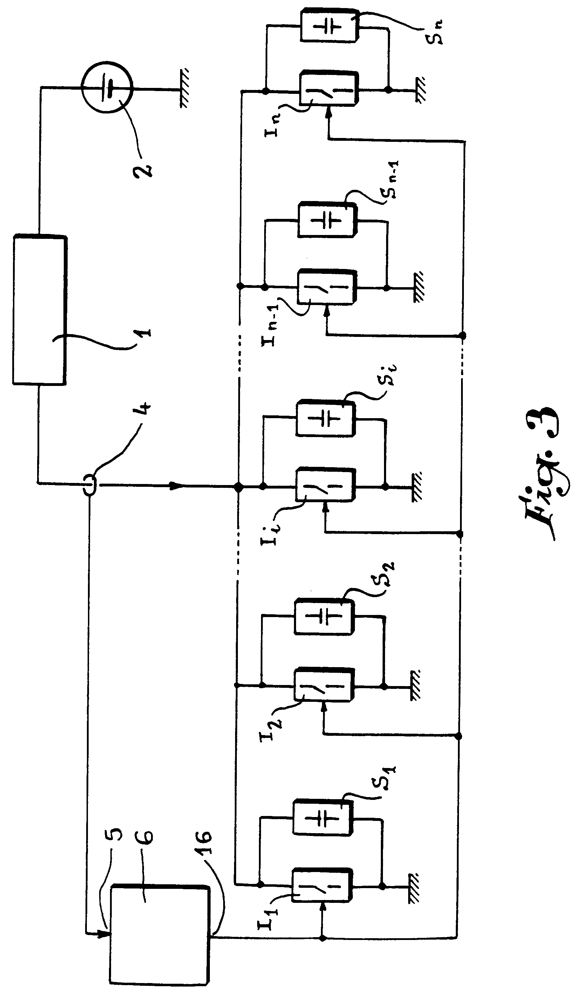

Conformément à l'invention, une telle mise en parallèle d'une kyrielle de petits interrupteurs statiques pour remplacer un ou deux gros interrupteurs statiques du commerce, est cependant réalisée grâce au montage particulier qui sera maintenant explicité en référence à la fig. 3.

Cette fig. 3 représente donc un interrupteur statique destiné à couper une très forte surintensité, par exemple 1200 ampères, étant bien entendu que l'on pouvait très bien réaliser, avec les inconvénients précédemment cités, un tel interrupteur en appliquant le schéma de la fig. 1 et en utilisant un ou deux gros thyristors 3 du commerce, et en associant à chaque thyristor un circuit SNUBBER 8.

Sur cette fig. 3, les éléments (1, 2, 4, 5, 6) qui sont soit identiques, soit semblables à ceux de la fig. 3, portent, pour permettre une comparaison aisée, les mêmes chiffres de référence.

Conformément à l'invention, le thyristor GTO 3 et son SNUBBER 8 sont ici remplacés :
- Le thyristor 3 par n "petits" thyristor GTO I₁, I₂..., Iᵢ,... Iₙ₋₁, Iₙ, qui sont branchés en parallèle comme représenté. Dans cet exemple particulier, n est choisi égal à douze. Tous ces thyristors sont déclenchés en parallèle et simultanément sur leur gâchette par la sortie 16 du circuit à seuil 6 : en conséquence, les connexions entre cette sortie 16 et chaque gâchette sont toutes rigoureusement d'égale longueur.
- Le SNUBBER 8 par (n) circuits SNUBBER S₁, S₂,.., Sᵢ,..., Sₙ, qui sont eux-aussi branchés en parallèle sur l'ensemble des thyristors I₁ à Iₙ, mais qui sont placés ici chacun entre deux thyristors de manière à réaliser une suite alternée de thyristors et de circuits SNUBBER : thyristor I₁, circuit SNUBBER S₁, thyristor I₂, circuit SNUBBER S₂,..., thyristor Iᵢ, circuit SNUBBER Sᵢ..., thyristor Iₙ₋₁, circuit SNUBBER Sₙ₋₁, thyristor In, circuit SNUBBER Sₙ. Bien entendu, les connexions entre chaque SNUBBER (S₁ par exemple) et le thyristor associé (I₁) sont les plus courtes possible afin de diminuer au maximum les self-inductances parasites ℓ précitées (voir fig. 2).

Selon une caractéristique intéressante, les douze thyristors GTO I₁ à Iₙ, qui doivent donc chacun être aptes à couper une surintensité de 100 ampères, sont choisis parmi les thyristors de commerce qui sont donnés pour une surintensité "maximale", ou "I_{TCM}" (courant maximal qu'il est possible de couper par la gâchette), beaucoup plus faible. Par exemple, ce sont des thyristors GTO vendus par "MOTOROLA" sous la référence "MGTO 1200", qui sont donnés pour un I_{TCM} de 50 ampères. Les inventeurs se sont en effet rendu compte que de tels thyristors pouvaient, contrairement à toute attente résultant des données du constructeur, parfaitement convenir pour la présente utilisation.

C'est ainsi par exemple que les interrupteurs I₁ à Iₙ peuvent être d'autres composants commandables que des thyristors GTO, tels que : transistors IGBT, transistors bipolaires, transistors à effet de champ, etc... C'est ainsi également que le montage de la fig. 3 peut être simplifié en associant à deux thyristors un seul circuit SNUBBER dont la capacité du condensateur est calculée en conséquence. Autrement dit, il est également possible de réaliser une cellule élémentaire de commutation en associant à deux petits interrupteurs un seul circuit SNUBBER, chacun de ces deux petits interrupteurs étant positionné de part et d'autre du circuit SNUBBER : le disjoncteur statique apte à commuter les surintensités élevées est alors réalisé au moins partiellement par une juxtaposition (par mise en parallèle de ces cellules élémentaires. Les connexions entre le circuit SNUBBER et les deux thyristors qui l'encadrent sont toujours les plus courtes possible, comme mentionné précédemment.

## Revendications

1. Interrupteur statique de puissance à semi-conducteurs, apte à commuter des surintensités de l'ordre d'au moins plusieurs centaines d'ampères, voire de plus d'un millier d'ampères, caractérisé en ce qu'il est constitué, de façon modulaire, par le branchement en parallèle d'un grand nombre de petits interrupteurs statiques (I₁, I₂..., Iᵢ..., Iₙ) de faibles dimensions et caractéristiques de coupure, et d'une pluralité de circuits d'aide à la commutation, ou "SNUBBER" (S₁, S₂..., Sᵢ... Sₙ), propres chacun à protéger soit un soit deux de ces petits interrupteurs, et en ce que chacun de ces petits interrupteurs statiques (I₁, I₂..., Iₙ) est choisi parmi ceux qui sont donnés par le constructeur pour une surintensité de coupure plus faible que la surintensité que ce petit interrupteur doit, pour sa part, normalement couper dans ce montage en fonctionnement en surcharge de courant, compte-tenu de son branchement en parallèle avec les autres petits interrupteurs.

2. Interrupteur statique selon la revendication 1, caractérisé en ce qu'il est au moins partiellement réalisé par mise en parallèle de cellules élémentaires de commutation constituées chacune par l'association de deux petits interrupteurs et d'un seul circuit SNUBBER, chacun de ces deux petits interrupteurs étant positionné de part et d'autre de ce circuit SNUBBER.
